Europäisches Patentamt

**European Patent Office**

**Office européen des brevets**

(19)

(11) Numéro de publication : **0 076 005**
**B1**

(12) **FASCICULE DE BREVET EUROPÉEN**

(45) Date de publication du fascicule du brevet :
20.02.85

(51) Int. Cl.⁴ : **H 03 K 17/74**, H 03 M   1/38

(21) Numéro de dépôt : **82201192.0**

(22) Date de dépôt : **24.09.82**

(54) **Commutateur analogique de courant en technologie bipolaire.**

(30) Priorité : **25.09.81 FR 8118099**

(43) Date de publication de la demande :
**06.04.83 Bulletin 83/14**

(45) Mention de la délivrance du brevet :
**20.02.85 Bulletin 85/08**

(84) Etats contractants désignés :
**DE FR GB IT**

(56) Documents cités :
**ELECTRONICS LETTERS, vol. 9, no. 6, 22 mars 1973, pages 131-132, Hitchin Herts (GB) S. MARJANOVIC: "High-accuracy digital-analogue convertor"**
**INSTRUMENTS AND EXPERIMENTAL TECHNIQUES, no. 6, novembre-décembre 1969, pages 1459-1460, New York (USA); N.N. BUTORIN: "Diode switching element in a code-to-voltage converter"**

(73) Titulaire : **TELECOMMUNICATIONS RADIOELECTRI-**
**QUES ET TELEPHONIQUES T.R.T.**
**88, rue Brillat Savarin**
**F-75013 Paris (FR)**
**FR**
**N.V. Philips' Gloeilampenfabrieken**
**Groenewoudseweg 1**
**NL-5621 BA Eindhoven (NL)**
**DE GB IT**

(72) Inventeur : **Pelletier, Joel**
**SOCIETE CIVILE S.P.I.D. 209 rue de l'Université**
**F-75007 Paris (FR)**
Inventeur : **Breuillard, Robert**
**SOCIETE CIVILE S.P.I.D. 209 rue de l'Université**
**F-75007 Paris (FR)**

(74) Mandataire : **Charpail, François et al**
**Société Civile S.P.I.D. 209, rue de l'Université**
**F-75007 Paris (FR)**

Jouve, 18, rue St-Denis, 75001 Paris, France

## Description

L'invention concerne un commutateur analogique de courant réalisé en technologie bipolaire dans lequel le circuit de commutation comporte une diode commutatrice et un transistor intermédiaire d'isolement dont l'émetteur est relié à une source de courant et dont le collecteur est relié à l'anode de ladite diode commutatrice, la borne d'émetteur dudit transistor intermédiaire, les bornes d'anode et de cathode de ladite diode commutatrice constituant successivement l'entrée de signal, l'entrée de signal de commutation et la sortie de signal dudit commutateur, ledit signal de commutation imposant à ladite diode commutatrice soit l'état conducteur pour lequel le courant injecté par ladite source dans ledit transistor intermédiaire est transmis vers ladite sortie de signal, soit l'état non conducteur pour lequel ledit courant est dérivé vers ladite entrée de signal de commutation.

Un tel circuit de commutation est connu par le brevet anglais n° 1 379 591 dans lequel le transistor intermédiaire à faible capacité de sortie a été introduit pour isoler la source de courant de la diode commutatrice et réduire ainsi la capacité parasite du dispositif. Par ailleurs, la polarisation de ce transistor nécessite l'application sur sa base d'un potentiel fixe fourni par une source de tension extérieure. Le but de l'invention est de substituer à cette source extérieure de polarisation un circuit intégré permettant d'assurer l'auto-polarisation du transistor intermédiaire. A cet effet et conformément à l'invention, ladite auto-polarisation est obtenue au moyen d'un deuxième transistor de même type de conduction dont le collecteur rétrocouplé sur la base est relié à la base dudit transistor intermédiaire et à l'anode d'une deuxième diode, les émetteurs dudit deuxième transistor et dudit transistor intermédiaire d'une part et les cathodes de ladite deuxième diode et de ladite diode commutatrice d'autre part étant interconnectés.

La description suivante en regard des dessins annexés, le tout donné à titre d'exemple fera bien comprendre comment l'invention peut être réalisée.

La figure 1a représente le schéma du commutateur analogique de courant conforme à l'invention.

La figure 1b montre le schéma du même commutateur en vue d'une réalisation sous forme de circuit intégré.

La figure 2 montre le schéma d'un assemblage de n commutations identiques conformes au schéma de la figure 1b utilisable pour la conversion numérique-analogique du signal.

Sur la figure 1a, le circuit de commutation comporte la diode commutatrice $D_c$ et le transistor intermédiaire $T_i$ de type PNP isolant la source de courant S de la diode $D_c$, l'émetteur de $T_i$ étant relié à S et son collecteur à l'anode de $D_c$. La borne d'émetteur de $T_i$ et les bornes d'anode et de cathode de $D_c$ constituent successivement l'entrée de signal $e_1$, l'entrée de signal de commutation $e_2$ et la sortie de signal s du commutateur.

Pour que le courant $I_{e1}$ injecté par la source S sur l'entrée $e_1$ se retrouve transmis de la sortie s ou dérivé vers l'entrée de signal de commutation $e_2$ selon la valeur du signal de commutation appliqué sur $e_2$, le transistor $T_i$ doit être polarisé de manière à être en permanence conducteur. Dans l'art antérieur cette polarisation est assurée par une source extérieure de tension qui porte la base de $T_i$ à un potentiel négatif. Le courant injecté $I_{e1}$ est égal au courant émetteur $I_E$ de $T_i$. Le courant $I_s$ transmis de s ou le courant $I_{e2}$ dérivé vers $e_2$ est alors égal au courant collecteur $\alpha I_E$ de $T_i$ :

$$I_s = I_{e2} = \alpha I_E = \frac{\beta}{\beta + 1} I_E$$

$\alpha$ et $\beta$ étant respectivement les gains de courant en base commune et en émetteur commun de $T_i$.

Il est possible de s'affranchir de la source extérieure de polarisation grâce à l'auto-polarisation de $T_i$ obtenue conformément à l'invention au moyen du transistor T de type PNP dont le collecteur rétrocouplé sur la base est relié à la base de $T_i$ et à l'anode de la diode D, les émetteurs de T et $T_i$ d'une part et les cathodes de D et $D_c$ d'autre part étant interconnectés.

Les transistors $T_i$ et T supposés identiques ont les mêmes caractéristiques de courants et de gains. Le courant injecté $I_{e1}$ est donc égal à la somme $2 I_E$ des courants émetteurs de $T_i$ et T. Le courant dérivé $I_{e2}$ est toujours égal à $\alpha I_E$, mais dans le courant transmis $I_s$, le courant de polarisation $I_o$ de T se superpose d'une façon permanente au courant collecteur $\alpha I_E$ de $T_i$. Ce courant $I_o$ est la somme des courants base de $T_i$ et T et du courant collecteur de $T_i$ :

$$I_o = 2(1 - \alpha) I_E + \alpha I_E = (2 - \alpha) I_E .$$

On a donc :

$$I_s = \alpha I_E + (2 - \alpha) I_E .$$

La tension de polarisation du circuit entre ses bornes d'entrée $e_1$ et de sortie s est égale à deux fois la tension de polarisation de la diode émetteur-base d'un transistor soit environ 1,6 Volt.

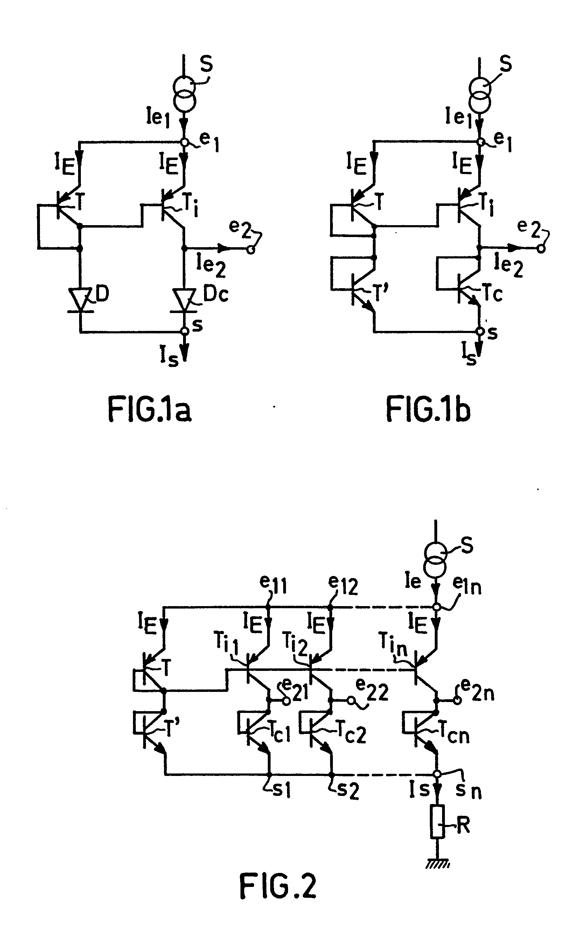

Dans une réalisation sous forme de circuit intégré du commutateur conforme à l'invention schématisée sur la figure 1b, les diodes $D_c$ et D sont remplacées par les diodes émetteur-base de deux transistors $T_c$ et T' de type NPN dont les collecteurs rétrocouplés sur les bases sont reliés respectivement aux collecteurs de $T_i$ et de T et dont les émetteurs sont interconnectés sur la sortie de signal.

Le fonctionnement des commutateurs schématisés sur les figures 1a et 1b est affecté par la valeur non négligeable du courant de polarisation constituant une composante permanente du courant transmis. L'expression de $I_s$ calculée ci-dessus montre en effet que cette composante permanente est du même ordre de grandeur que la composante intermittente égale au courant collecteur de $T_i$ ce qui exclut l'obtention du « O » sur le signal transmis. Cet inconvénient se trouve pratiquement éliminé en utilisant le circuit schématisé sur la figure 2 auto-polarisé conformément à l'invention au moyen des transistors T et T' et formé à partir de n circuits de commutation ($T_{c1} - T_{i1}$, ..., $T_{cn} - T_{in}$) identiques selon le schéma de la figure 1b avec les n entrées de signal $e_{11}$, $e_{12}$, ... $e_{1n}$ interconnectées et reliées à la source de courant S, les n bases des transistors $T_{i1}$, $T_{i2}$, ... $T_{in}$ interconnectées sur les collecteurs de T et T' et les n sorties de signal $s_1$, $s_2$, ... $s_n$ interconnectées sur une borne d'une résistance R dont l'autre borne est reliée à la masse.

Le courant $I_e$ injecté par la source de courant S, comme des courants émetteurs des n transistors $T_{i1}$, $T_{i2}$, ... $T_{in}$ et du transistor T est égal à $(n + 1)I_E$ si tous les transistors sont supposés identiques. Si les n diodes commutatrices formées par les jonctions émetteur-base des transistors $T_{c1}$, $T_{c2}$, ... $T_{cn}$ reçoivent sur leurs bornes d'entrée de signal de commutation $e_{21}$, $e_{22}$, ... $e_{2n}$, des valeurs de signaux qui les mettent simultanément dans $p \leqslant n$ états non conducteurs et dans $n - p$ états conducteurs, la somme des courants dérivés vers les entrées de signal de commutation correspondantes est

$$I_m = p \frac{\beta}{\beta + 1} I_E \,.$$

Le courant de polarisation $I_o$ est la somme des courants base et collecteur de T et des courants base de $T_{i1}$, $T_{i2}$ ... $T_{in}$. On obtient tous calculs effectués :

$$I_o = \left( 1 - \frac{\beta}{\beta + 1} \frac{n}{n + 1} \right) (n + 1)\, I_E \,.$$

Le courant transmis $I_s$ est égal à la somme des courants dans les $n - p$ diodes commutatrices qui se trouvent dans leur état conducteur et à laquelle se superpose le courant de polarisation.

$$I_s = (n - p) \frac{\beta}{\beta + 1} I_E + \left( 1 - \frac{\beta}{\beta + 1} \frac{n}{n + 1} \right) (n + 1)\, I_E \,.$$

On obtient ainsi aux bornes de la résistance R suivant les valeurs successives données à p une loi de tension déterminée.

Un tel circuit peut être avantageusement utilisé pour la réalisation de convertisseurs numérique-analogique.

Le circuit de la figure 2 peut également être considéré comme une ligne d'affaiblissement dont on définit le coefficient de transmission a par le rapport de la somme des courants dérivés à la masse $I_m$ au courant injecté dans la ligne $I_e$. Le courant transmis utilisable $I_s$ s'écrit :

$$I_s = I_e - I_m = I_e \left( 1 - \frac{I_m}{I_e} \right) = I_e (1 - a).$$

On en déduit l'affaiblissement introduit par la ligne $(I_s/I_e) = 1 - a$. On définit par ailleurs le coefficient de réflexion $\rho$ de la ligne par le rapport du courant dérivé $I_m$ au courant de polarisation $I_o$.

Compte tenu des expressions déjà établies de $I_e$, $I_m$ et $I_o$, les coefficients de transmission et de réflexion ont pour valeurs :

$$a = \frac{I_m}{I_e} = \frac{p}{n + 1} \frac{1}{1 + \dfrac{1}{\beta}}, \quad \rho = \frac{I_m}{I_o} = \frac{p}{1 + \dfrac{n + 1}{\beta}} \,.$$

Si les $n + 1$ transistors $T_i$ et T ne sont pas rigoureusement identiques on peut écrire

$$a = \sum_p a_j \text{ avec } a_j = \frac{I_{e2j}}{I_e} \,,$$

$I_{e2j}$ étant le courant dérivé vers la borne d'entrée de signal de commutation $e_{2j}$. Le courant transmis utilisable $I_s$ devient :

$$I_s = I_e \left( 1 - \sum_p a_j \right) \,.$$

**Revendications**

1. Commutateur analogique de courant réalisé en technologie bipolaire dans lequel le circuit de commutation comporte une diode commutatrice ($D_c$) et un transistor intermédiaire d'isolement ($T_i$) dont

l'émetteur est relié à une source de courant (S) et dont le collecteur est relié à l'anode de ladite diode commutatrice, la borne d'émetteur dudit transistor intermédiaire, les bornes d'anode et de cathode de ladite diode commutatrice constituant successivement l'entrée de signal ($e_1$), l'entrée de signal de commutation ($e_2$) et la sortie de signal (s) dudit commutateur, ledit signal de commutation imposant à ladite diode commutatrice soit l'état conducteur pour lequel le courant injecté par ladite source dans ledit transistor intermédiaire est transmis vers ladite sortie de signal, soit l'état non conducteur pour lequel ledit courant est dérivé vers ladite entrée de signal de commutation, caractérisé en ce que ledit transistor intermédiaire est auto-polarisé au moyen d'un deuxième transistor (T) de même type de conduction dont le collecteur rétrocouplé sur la base est relié à la base dudit transistor intermédiaire et à l'anode d'une deuxième diode (D), les émetteurs dudit deuxième transistor et dudit transistor intermédiaire d'une part et les cathodes de ladite deuxième diode et de ladite commutatrice d'autre part étant interconnectés.

2. Commutateur formé à partir d'un assemblage de n circuits de commutation identiques selon la revendication 1, caractérisé en ce que lesdites n entrées de signal ($e_{11}$, $e_{12}$, ... $e_{1n}$) sont interconnectées sur l'entrée de signal dudit commutateur reliée à ladite source de courant, les n bases desdits transistors intermédiaires ($T_{i1}$, $T_{i2}$ ... $T_{in}$) sont interconnectées et lesdites n sorties de signal ($s_1$, $s_2$, ... $s_n$) sont interconnectées sur la sortie de signal dudit commutateur, lesdites n diodes commutatrices recevant sur leurs bornes d'entrées de signal de commutation ($e_{21}$, $e_{22}$, ... $e_{2n}$) des valeurs de signaux qui les mettent simultanément dans $p \leqslant n$ états non conducteurs et dans $n - p$ états conducteurs.

## Claims

1. An analogue current switch in bipolar technology·in which the switching circuit comprises a switching diode ($D_c$) and an intermediate isolating transistor ($T_i$) whose emitter is connected to a current source (S) and whose collector is connected to the anode of said switching diode, the emitter of said intermediate transistor, the anode and the cathode of said switching diode respectively constituting the signal input ($e_1$), the switching signal input ($e_2$) and the signal output (s) of said switch, which switching signal either turns on said switching diode, in which case the current injected into said intermediate transistor by said source is transferred to said signal output, or turns off said transistor, in which case said current is applied to said switching-signal input, characterized in that said intermediate transistor is biassed by a second transistor (T) of the same conductivity type, whose collector, which is coupled to its base, is connected to the base of said intermediate transistor and to the anode of a second diode (D), the emitters of said second transistor and said intermediate transistor being interconnected and the cathodes of said second diode and said switching diode being interconnected.

2. A switch formed by means of an arrangement of n identical switching circuits as claimed in Claim 1, characterized in that said n signal inputs ($E_{11}$, $E_{12}$ ... $E_{1n}$) are connected to the signal input of said switch, which is connected to said current source, the n bases of said intermediate transistors ($T_{i1}$, $T_{i2}$ ... $T_{in}$) are interconnected, and said n signal outputs ($s_1$, $s_2$, ... $s_n$) are connected to the signal output of said switch, said n switching diodes receiving signals of such values at their switching-signal input terminals ($e_{21}$, $e_{22}$, ... $e_{2n}$) that said diodes are switched simultaneously to $p \leqslant n$ non-conductive states and $n - p$ conductive states.

## Ansprüche

1. Analog-Stromschalter in Bipolartechnologie, in dem der Schaltkreis eine Schaltdiode ($D_c$) und einen Isolier-Zwischentransistor ($T_i$) enthält, dessen Emitter an eine Stromquelle (S) und dessen Kollektor an die Anode der Schaltdiode angeschlossen ist, wobei der Emitteranschluss des Zwischentransistors und die Anoden- und Kathodenanschlüsse der Schaltdiode den Signaleingang ($e_1$), den Schaltsignaleingang ($e_2$) bzw. den Signalausgang (s) des Schalters bilden, wobei das Schaltsignal die Schaltdiode entweder in den leitenden Zustand, bei dem der aus der Quelle zugeführte Strom im Transistor dem Signalausgang zugeführt wird, oder in den Sperrzustand versetzt, bei dem der Strom an den Schaltsignaleingang gelegt wird, dadurch gekennzeichnet, dass der Zwischentransistor mit Hilfe eines zweiten Transistors (T) mit derselben Leitfähigkeit autopolarisiert wird, dessen zur Basis rückgekoppelter Kollektor an die Basis des Zwischentransistors und an die Anode einer zweiten Diode (D) angeschlossen ist, wobei die Emitter des zweiten Transistors und des Zwischentransistors einerseits und die Kathoden der zweiten Diode und der Schaltdiode andererseits miteinander verbunden sind.

2. Schalter, aufgebaut aus einer Anordnund von n identischen Schaltkreisen nach Anspruch 1, dadurch gekennzeichnet, dass die n Signaleingänge ($e_{11}$, $e_{12}$ ... $e_{1n}$) mit dem Signaleingang des Schalters verbunden sind, der mit der Stromquelle verbunden ist, dass die n Basen der Zwischentransistoren ($T_{i1}$, $T_{i2}$ ... $T_{in}$) miteinander und die n Signalausgänge ($s_1$, $s_2$ ... $s_n$) über den Signalausgang des Schalters verbunden sind, wobei die n Schaltdioden an ihren Schaltsignaleingängen ($e_{21}$, $e_{22}$, ... $e_{2n}$) Signalwerte empfangen, die sie gleichzeitig in $p \leqslant n$ Sperrzustände und in $n - p$ leitende Zustände versetzen.

FIG.1a          FIG.1b

FIG.2